# EUROPEAN PATENT APPLICATION

(11) **EP 4 823 247 A1**
(43) Date of publication of application: **14.10.2026**
(21) Application number: 25168989.9
(22) Date of filing: 08.04.2025
(51) Int. Cl.: H05K 1/02

(54) **LUMINAIRE OPERATING DEVICE WITH REDUCED NOISE EMISSION**

(71) Applicant: Tridonic GmbH & Co. KG, 6851 Dornbirn (AT)
(72) Inventor: Schneider, Miguel Philipp, 6851 Dornbirn (AT); Lochmann, Frank, 6851 Dornbirn (AT)
(74) Representative: Rupp, Christian

(57) **Abstract**

The invention relates to an operating device (10) for a luminaire (20). The operating device (10) comprises a printed circuit board, PCB (11), and an operating circuit which is at least partially arranged on the PCB (11). The operating circuit (12) comprises at least one capacitor (21) mounted on the PCB (11), wherein the capacitor (21) is subjected to a fluctuating voltage signal during an operation of the operating device (10). The PCB (11) comprises one or more slots (31) which are arranged on at least two sides of the capacitor (21).

## Description

### TECHNICAL FIELD OF THE INVENTION

The invention relates to an operating device for a luminaire, in particular to an LED driver, which generates less noise during operation.

### BACKGROUND OF THE INVENTION

An LED driver is an electronic device that regulates the power supplied to a connected LED load. Typically, a number of capacitors are installed in an LED driver. Some of these capacitors serve the function of stabilizing a fluctuating signal, e.g., to generate a stable output voltage.

However, the fluctuating signal can induce an oscillation or vibration of the capacitors. This oscillation or vibration can be caused by the Piezo effect and can be transferred to other components of the driver, in particular to a PCB. As a result, the PCB deforms mechanically (e.g., vibrates), which leads to an audible noise, in particular a whistling sound. This whistling is perceived as disturbing and should be avoided.

To mitigate this issue, it is known to mount the capacitors via noise dampening connectors on the PCB. However, this solution is expensive and leads to additional efforts. For instance, the connectors need additional space on the PCB and are often not compatible with conventional soldering techniques.

### SUMMARY OF THE INVENTION

Thus, it is an object of the invention to reduce the noise generated by an operating device for a luminaire in a cost-efficient and easy to implement manner.

The object is achieved by the solution provided in the enclosed independent claims. Advantageous implementations of the present invention are further defined in the dependent claims.

According to a first aspect, the invention relates to an operating device for a luminaire. The operating device comprises: a printed circuit board (PCB); and an operating circuit which is at least partially arranged on the PCB; wherein the operating circuit comprises at least one capacitor mounted on the PCB, wherein the capacitor is subjected to a fluctuating voltage signal during an operation of the operating device; and wherein the PCB comprises one or more slots which are arranged on at least two sides of the capacitor.

This achieves the advantage that a luminaire operating device with reduced noise emission is provided. For instance, the fluctuating voltage signal induces a vibration and/or oscillation of the at least one capacitor. By means of the slots, a section of the PCB on which the capacitor is mounted can be mechanically decoupled from the remaining PCB. As a consequence, a transfer of the capacitor vibrations/oscillations to the remaining PCB is strongly reduced, leading to a significant reduction in noise emission due to PCB vibration.

Furthermore, this achieves the advantage that standard capacitors and standard soldering techniques, e.g. wave soldering, can be used to mount the capacitors, leading to a significant cost reduction compared to, e.g., the use of noise dampening connectors for mounting the capacitors.

The PCB can comprise a substrate or base material, wherein conductive traces for the electrical signal, e.g. copper lines, are arranged on the substrate.

The slots can be longitudinal cuts or openings in the substrate or base material of the PCB.

The slots can be arranged on two, three or four sides of a PCB section on which the at least one capacitor is mounted.

In an implementation form, the one or more slots comprise one or two L-shaped slots. This achieves the advantage that an efficient noise reduction can be achieved.

In an implementation form, the one or more slots comprise one or two U-shaped slots. This achieves the advantage that an efficient noise reduction can be achieved.

In an implementation form, the one or more slots are arranged around a section of the PCB on which the at least one capacitor is mounted; wherein the one or more slots cover more than 50% of all side surfaces of the section.

In an implementation form, the PCB comprises a further slot which is arranged below the capacitor. This achieves the advantage that an additional noise reduction can be achieved. For instance, the further slot allows the PCB to locally deform below the capacitor and thereby to absorb at least a part of the capacitor vibration.

In an implementation form, the one or more slots and the further slot merge with each other.

In an implementation form, the merged slots form an S-shaped slot.

In an implementation form, the at least one capacitor is mounted on a first side of the PCB; wherein the operating circuit comprises at least one further capacitor mounted on an opposite second side of the PCB, and wherein the at least one further capacitor is arranged directly opposite the at least one capacitor. This achieves the advantage that an additional noise reduction can be achieved. For instance, a vibration of the capacitors on the two opposite sides of the PCB can at least partially cancel each other out.

In an implementation form, the capacitor is connected to the remaining operating circuit via at least one conductive trace on the PCB.

In an implementation form, the signal is a periodically fluctuating voltage signal, in particular a voltage signal that fluctuates according to a PWM signal.

In an implementation form, the operating circuit comprises a switch which is alternately turned on and off causing at least a part of the fluctuation of the voltage signal. For instance, the operating device can be a PWM driver and/or a switched mode power supply. The switch can be operated by an internal PWM signal.

In an implementation form, the at least one capacitor is configured to smoothen the fluctuating voltage signal. For instance, the at least one capacitor is configured to provide a stable DC output voltage. The operating circuit can be configured to provide the smoothened signal to the luminaire, in particular an LED luminaire connected to the operating device.

In an implementation form, the operating device is an LED driver, in particular a constant voltage LED driver.

The operating circuit can be a driver circuit. The operating circuit can be or can comprise a converter circuit. The luminaire can be an LED luminaire.

### BRIEF DESCRIPTION OF THE DRAWINGS

Exemplary embodiments of the invention are now further explained with respect to the drawings by way of example only, and not for limitation. In the drawings:
- Fig. 1: shows a schematic diagram of an operating device for a luminaire according to an embodiment;
- Fig. 2: shows a circuit diagram of an operating circuit of an operating device according to an embodiment;
- Figs. 3A-F: show top views of a PCB of an operating device according to exemplary embodiments; and
- Fig. 4: shows a cross section of a PCB of an operating device according to an embodiment.

### DETAILED DESCRIPTION OF EMBODIMENTS

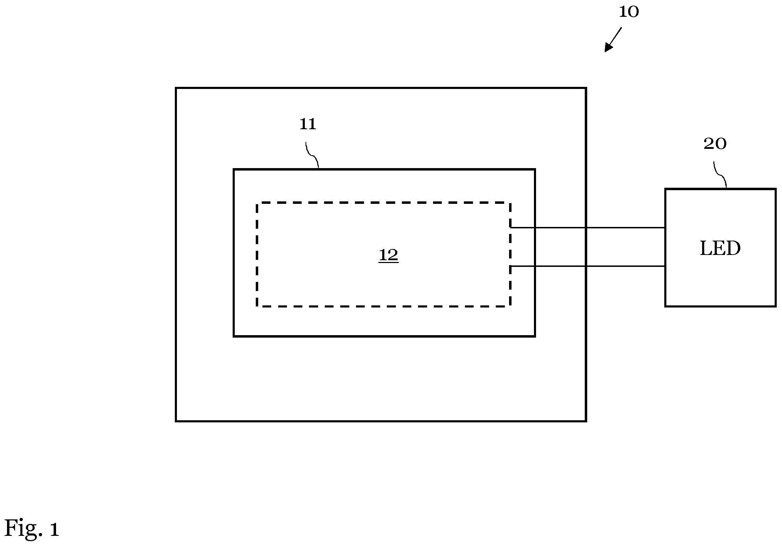

Fig. 1 shows a schematic diagram of an operating device 10 for a luminaire 20 according to an embodiment. The operating device 10 comprises a PCB 11 and an operating circuit 12 which is at least partially arranged on the PCB 11.

The operating circuit 12 comprises at least one capacitor mounted on the PCB 11, wherein the capacitor is subjected to a fluctuating voltage signal during an operation of the operating device 10. The PCB 11 comprises one or more slots which are arranged on at least two sides of the capacitor.

The fluctuating voltage signal can induce a vibration and/or oscillation of the at least one capacitor.

The vibration and/or oscillation of the at least one capacitor can be caused by the Piezo effect. For instance, the fluctuating signal causes a periodic elastic deformation of the capacitor (or a part thereof). This vibration/oscillation can be transferred to the PCB board below the capacitor.

Due to the slots, a section of the PCB on which the at least one capacitor is mounted can be mechanically decoupled from the remaining PCB. This "decoupling" strongly reduces a transmission of the capacitor vibrations/oscillations to the remaining PCB, leading to a significant reduction in noise emission due to PCB vibrations.

The PCB 11 can comprise a substrate or base material, wherein conductive traces for the electrical signal, e.g. copper lines, are arranged on the substrate. Some or all electrical components of the operating circuit 12, e.g. resistors, diodes, capacitors, can be arranged on the PCB and interconnected by the conductive traces. The PCB 11 can be a single-sided or double-sided PCB.

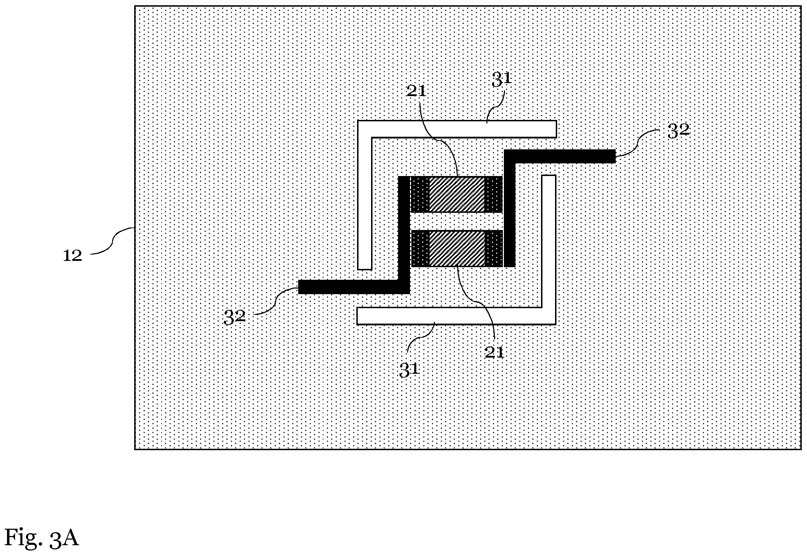

The slots can be arranged on two, three or four sides of a PCB section on which the at least one capacitor is mounted. Possible arrangements of the slots on the PCB 11 will be explained in conjunction with Figs. 3A-F below.

The operating device 10 can be an LED driver, in particular a constant voltage LED driver. The luminaire 20 can be an LED luminaire, e.g. an LED module or a string of LEDs.

The operation of the operating device 10 may refer to a phase during which the operating device, e.g. the LED driver, provides electrical energy to the luminaire 20.

The operating circuit 12 can be a driver circuit of the LED driver. The driver circuit can be or can comprise a converter circuit.

The capacitor being subjected to the fluctuating voltage signal may refer to the fluctuating voltage signal being applied across the capacitor by the operating circuit 12.

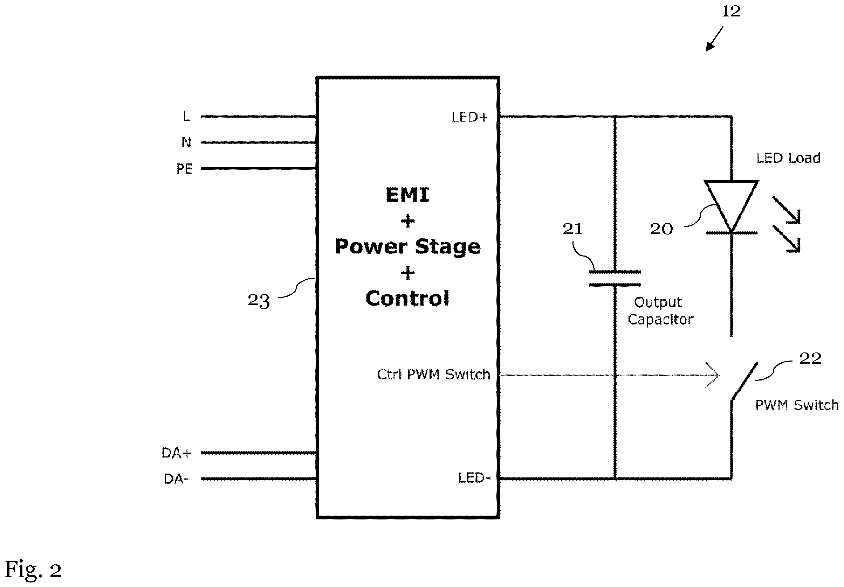

Fig. 2 shows a circuit diagram of the operating circuit 12 according to an embodiment.

The operating circuit 12 can comprise a switch which is alternately turned on and off causing at least a part of the fluctuation of the voltage signal.

For instance, the switch can be operated by an internal PWM signal, i.e., alternately turned on and off according to the PWM signal. This PWM control signal can be provided by a control unit, e.g. a microcontroller or ASIC.

The fluctuating voltage signal can be a periodically fluctuating voltage signal, e.g. a square wave or rectangular wave signal.

In particular, the voltage signal fluctuation is caused by the PWM control of the switch 22, such that the signal fluctuates according to the PWM control signal. By means of this controlled fluctuation, an amount of electrical power delivered to the luminaire 20 can be controlled. For instance, the signal can be modulated at a frequency in the kHz range.

The fluctuation of the voltage signal can also comprise a ripple on the voltage signal.

The at least one capacitor 21 can be configured to smoothen and/or stabilize the fluctuating signal. For instance, the capacitor 21 can convert the modulated signal into a DC signal with stable voltage level.

The capacitor 21 can be an output capacitor. This output capacitor can provide the smoothened and/or stabilized signal at an output of the operating device 10. For instance, this signal can be applied across an LED load connected to the output, e.g. across the LED luminaire 20.

For instance, the at least one capacitor 21 is an electrolyte capacitor (ELCAP).

The operating circuit 12 can further comprise an EMI, power and/or control stage 23. Some or all of the electrical components of said stage(s) 23 can be mounted on the PCB 11.

For instance, the operating circuit 12 further comprises terminals for connecting to a mains power supply and/or a communication interface, e.g. a DALI interface DA+/DA-. The operating circuit 12 may further comprise terminals for connecting the luminaire 20 and/or the luminaire could be mounted on the PCB 11.

Each of Figs. 3A-F show a top view of the PCB 11 of the operating device 10 according to an exemplary embodiment. Thereby, in each case, the PCB 11 comprises one or more slots 31 which are arranged on at least two sides of the capacitor 21. In the example of Figs. 3A-F, the operating circuit 12 comprises two capacitors which are arranged adjacent to each other on one side of the PCB 11. However, this is only an example and the circuit 12 could instead comprise only one or more than two capacitors which are arranged adjacent to each other and surrounded by the slots 31.

The slots 31 can be longitudinal cuts or openings in the substrate or base plate of the PCB 11. The slots 31 can be slits, i.e., long and narrow openings.

The capacitor(s) 21 can be connected to the remaining operating circuit via at least one conductive trace 32 on the PCB 11. For instance, each capacitor 21 is connected to two traces 32. The traces 32 can be arranged to run past the slots, e.g., across bridging sections of the PCB that physically connect the section of the PCB surrounded by the slots 31 to the remaining PCB 11.

The slots 31 can comprise one or two L-shaped slots which are arranged around the capacitor(s) 21, as shown in Fig. 3A. An L-shaped slot can comprise two longitudinal sections which are arranged at a right angle to each other.

The L-shaped slots can be arranged around the section of the PCB 11 on which the capacitor(s) 21 are mounted. In this way, this section can be efficiently decoupled from the remaining PCB 11, such that oscillations of the capacitor are only transferred to the "decoupled" section of the PCB but not to the remaining PCB 11.

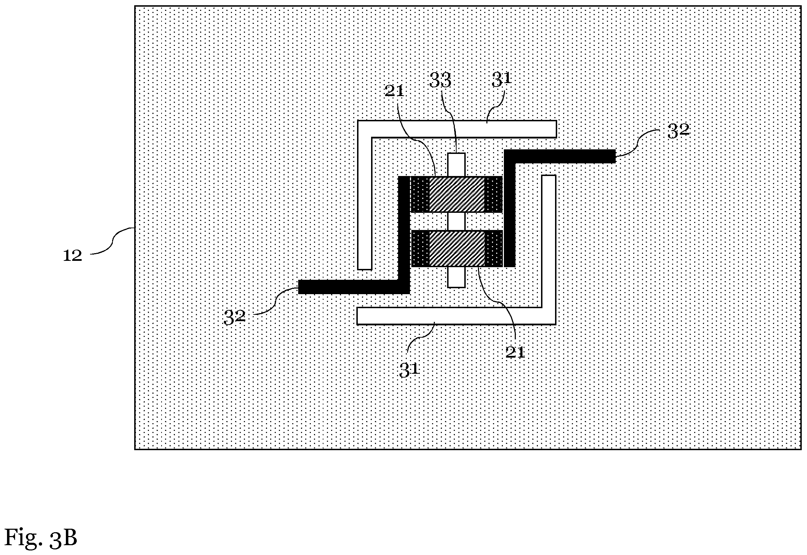

As shown in Fig. 3B, the PCB can comprise a further slot 33 which is arranged below a portion of the capacitors 21. For instance, the further slot 33 allows the PCB to locally deform below the capacitors 21 and thereby to absorb a part of the capacitor vibration. In this way, an additional noise reduction can be achieved.

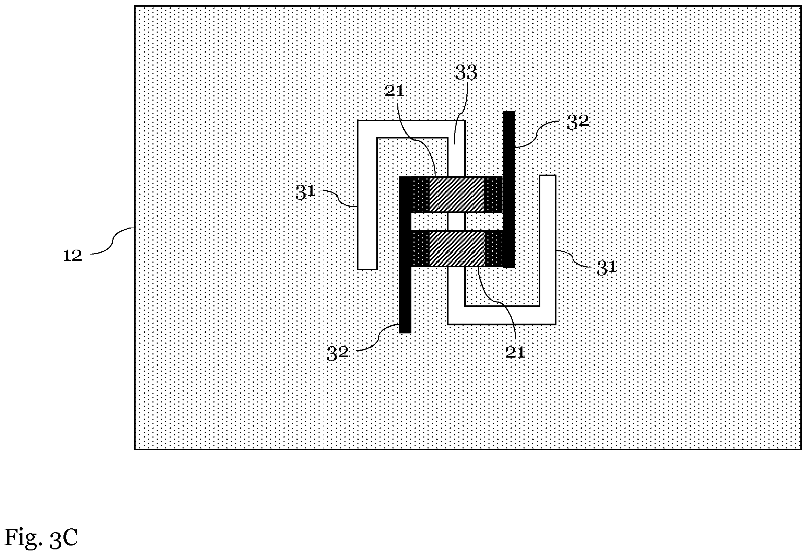

As shown in Fig. 3C, the slots 31 which are arranged around the capacitor(s) 21 and the further slot 33 can merge with each other, resulting in one longer slot. This "merged slot" can have an S-shape. This slot arrangement can result in an especially efficient absorption of capacitor vibrations/oscillations and, thus, reduced noise emission.

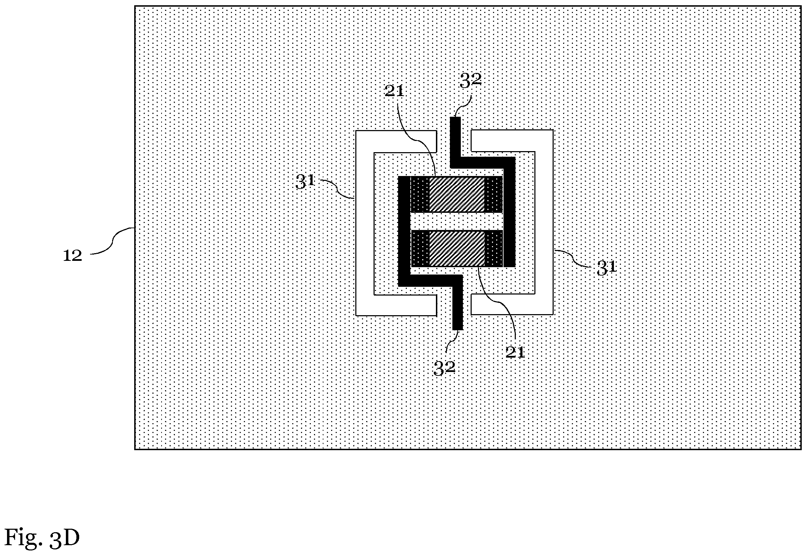

Furthermore, the one or more slots 31 can comprise one or two U-shaped slots which are arranged around the capacitor(s) 21, as shown in Fig. 3D. Similar to the L-shaped slots, also the U-shaped slots can decouple the capacitor section of the PCB from the remaining PCB 11 and thus reduce noise emission.

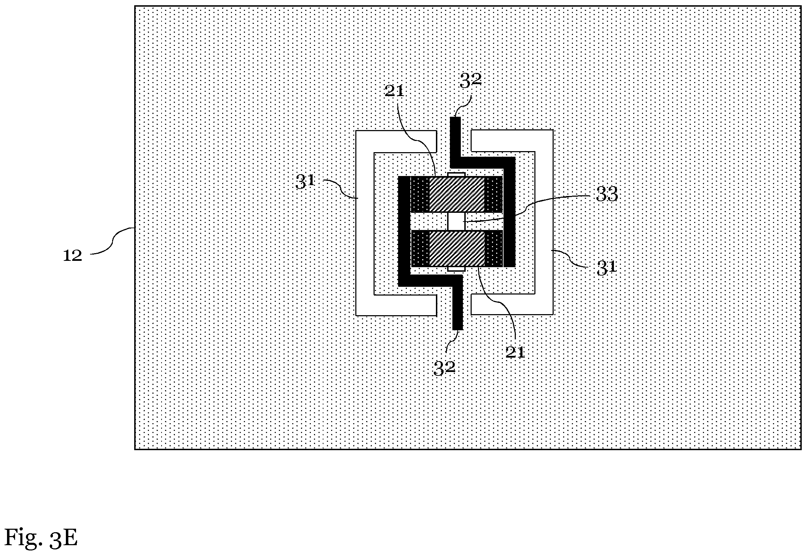

Fig. 3E shows a further example of the PCB 11, where two U-shaped slots are combined with a further slot 33 which is arranged below the capacitors 21.

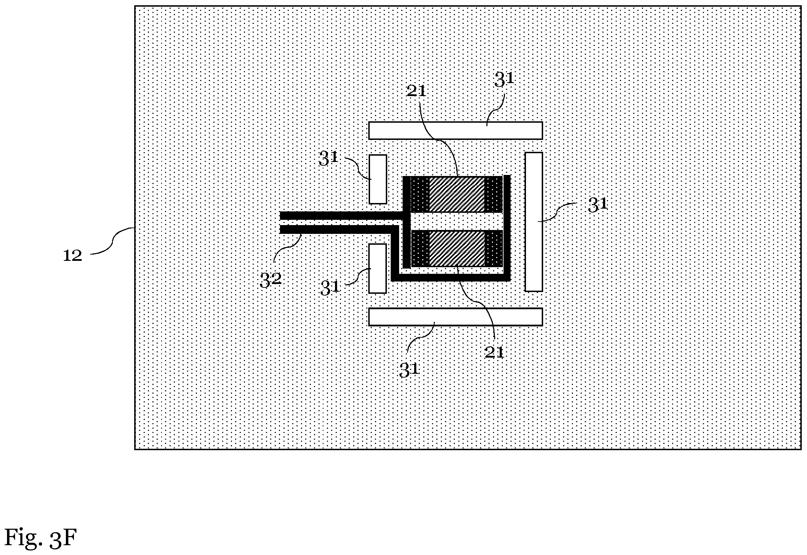

Fig. 3F shows an embodiment of the PCB 11 with five linear slots arranged around the capacitors 21.

For instance, at least 50% of all side of the capacitor section of the PCB (i.e., the section of the PCB that the capacitors are mounted on) can be covered by a slot. In this way, an efficient decoupling of the capacitor section from the remaining PCB 11 can be achieved.

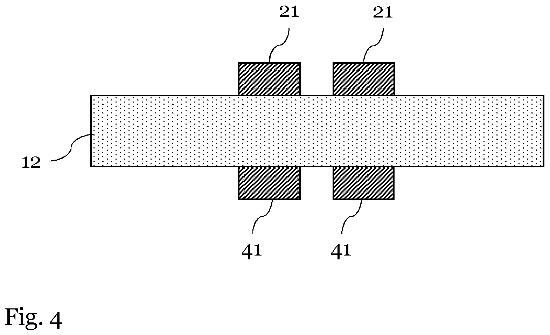

Fig. 4 shows a cross section of the PCB 11 according to an embodiment.

As shown in Fig. 4, the capacitors 21 can be mounted on a first side of the PCB 11, wherein further capacitors 41 are mounted on an opposite second side of the PCB 11. Thereby, each of the further capacitors 41 can be arranged directly opposite of one of the capacitors 21 on the first side.

With this orientation, vibrations of the capacitors 21, 41 on the two opposite sides of the PCB 11 can at least partially cancel each other out, leading to an additional noise reduction. This opposite arrangement of capacitors 21, 41 can be combined with the decoupling slots 31, 33 as **e.g.** shown in Figs. 3A-3F to achieve an even stronger noise reduction.

A noise reduction by means of the slots 31, 33 around and/or below the capacitors 21 and/or the opposite arrangement of capacitors 21, 41 on the PCB 11 has the further advantage that the capacitors can be mounted using conventional soldering techniques, e.g. wave soldering. This can lead to significant cost reduction compared to the use of noise dampening connectors below the capacitors 21.

Although the invention has been illustrated and described with respect to one or more implementations, equivalent alternations and modifications will occur to those skilled in the art upon the reading of the understanding of the specification and the annexed drawings. In addition, while a particular feature of the invention may have been disclosed with respect to only of the several implementations, such features may be combined with one or more other features of the other implementations as may be desired and advantage for any given or particular application.

## Claims

1. An operating device (10) for a luminaire (20), comprising:
a printed circuit board, PCB (11); and
an operating circuit which is at least partially arranged on the PCB (11);
wherein the operating circuit (12) comprises at least one capacitor (21) mounted on the PCB (11), wherein the capacitor (21) is subjected to a fluctuating voltage signal during an operation of the operating device (10); and
wherein the PCB (11) comprises one or more slots (31) which are arranged on at least two sides of the capacitor (21).

2. The operating device (10) of claim 1,
wherein the one or more slots (31) comprise one or two L-shaped slots.

3. The operating device (10) of claim 1 or 2,
wherein the one or more slots (31) comprise one or two U-shaped slots.

4. The operating device (10) of any one of the preceding claims,
wherein the one or more slots (31) are arranged around a section of the PCB (11) on which the at least one capacitor (21) is mounted;
wherein the one or more slots (31) cover more than 50% of all side surfaces of the section.

5. The operating device (10) of any one of the preceding claims,
wherein the PCB (11) comprises a further slot (33) which is arranged below the capacitor (21).

6. The operating device (10) of claim 5,
wherein the one or more slots (31) and the further slot (33) merge with each other.

7. The operating device (10) of claim 6,
wherein the merged slots form an S-shaped slot.

8. The operating device (10) of any one of the preceding claims,
wherein the at least one capacitor (41) is mounted on a first side of the PCB (11);
wherein the operating circuit (12) comprises at least one further capacitor (41) mounted on an opposite second side of the PCB (11), wherein the at least one further capacitor (41) is arranged directly opposite the at least one capacitor (21).

9. The operating device (10) of any one of the proceedings claim,
wherein the capacitor (21) is connected to the remaining operating circuit (12) via at least one conductive trace (32) on the PCB (11).

10. The operating device (10) of any one of the preceding claims,
wherein the voltage signal is a periodically fluctuating voltage signal, in particular a voltage signal that fluctuates according to a PWM signal.

11. The operating device (10) of any one of the preceding claims,
wherein the operating circuit (12) comprises a switch (22) which is alternately turned on and off causing at least a part of the fluctuation of the voltage signal.

12. The operating device (10) of any one of the preceding claims,
wherein the at least one capacitor (21) is configured to smoothen the fluctuating voltage signal;
wherein the operating circuit (12) is configured to provide the smoothened voltage signal to the luminaire (20), in particular an LED luminaire connected to the operating device.

13. The operating device (10) of any one of the preceding claims,
wherein the operating device (10) is an LED driver, in particular a constant voltage LED driver.
